# EUROPEAN PATENT SPECIFICATION

(11) **EP 3 144 623 B1**
(45) Date of publication and mention of the grant of the patent: **12.12.2018**
(21) Application number: 16188843.3
(22) Date of filing: 14.09.2016
(51) Int. Cl.: F28D 9/00, H02K 9/00, H02K 11/30, H05K 7/20, H02K 9/19, H02K 19/36, H02K 7/18

(54) **HEAT EXCHANGER AND COOLING SYSTEM FOR GENERATOR ELECTRONICS COOLING**
WÄREMTAUSCHER UND KÜHLSYSTEM ZUR KÜHLUNG EINER GENERATOR-ELEKTRONIK
ÉCHANGEUR DE CHALEUR ET SYSTÈME DE REFROIDISSEMENT D'ÉLECTRONIQUE DE GÉNÉRATEUR

(30) Priority: 21.09.2015 US 201514859866
(43) Date of publication of application: 22.03.2017
(73) Proprietor: Hamilton Sundstrand Corporation, Charlotte, NC 28277 (US)
(72) Inventor: PAL, Debabrata, Hoffman Estates, IL 60192 (US)
(74) Representative: Dehns

(56) References cited:
- EP-A1- 0 677 716
- DE-A1- 10 360 226
- DE-C1- 19 960 960
- GB-A- 2 095 756
- JP-A- 2005 188 920
- US-A- 3 513 907
- US-A- 5 105 875
- US-A- 5 271 248
- US-A1- 2004 050 544
- US-A1- 2008 110 603

## Description

### BACKGROUND

The present invention relates generally to systems for cooling multiple heat loads and, more particularly, to systems for cooling generators and associated electronics driven by gas turbine engines installed on aircraft, as e. g. known from US 5 271 248 A1 or US 5 105 875 A1.

Aircraft use a gas turbine engine to drive a generator, producing on-board electrical power. The electric power is used to operate instruments, environmental control systems, radar, and various other aircraft systems. The rotational speed of the gas turbine engine varies during the operation of the aircraft, increasing or decreasing speed to vary aircraft speed. Consequently, the input speed driving the generator varies along with the speed of the gas turbine engine. Additionally, the electrical load on the generator varies as various aircraft systems are engaged and disengaged. To maintain a substantially constant speed of the generator, a generator control module monitors the speed of the generator input shaft and the electrical load imposed on the generator. Because generator control modules typically include electronic components that have lower allowable maximum temperature limits compared to generator, some systems place the generator control module in a pressurized and temperature-controlled electronics bay within the aircraft. While placing the generator control unit within the electronics bay provides an acceptable environment for the electronics, the distance between the generator control unit and the generator increases the complexity of the generator system. Moreover, some aircraft require compact system configurations that do not allow electronics to be placed in separate bays.

Therefore, a need exists to develop a cooling system that enables electronics for operating the generator to be located outside of a temperature-controlled and pressurized bay.

EP 0677716 A1 discloses a prior art system as set forth in the preamble of claim 1.

### SUMMARY

According to the present invention, there is provided a system as set forth in claim 1.

There is further provided a method as set forth in claim 6.

Features of embodiments of the invention are set forth in the dependent claims.

### BRIEF DESCRIPTION OF THE DRAWINGS

FIG. 1 is a schematic diagram of a multi-circuit system for cooling a first heat source and a second heat source adjacent to the first heat source.
FIG. 2 is a cross-sectional view taken along a longitudinal direction of a multi-core heat exchanger having thermally-isolated cores.
FIG. 3 is a cross-sectional view taken perpendicular to the longitudinal direction of the multi-core heat exchanger of FIG. 2.

### DETAILED DESCRIPTION

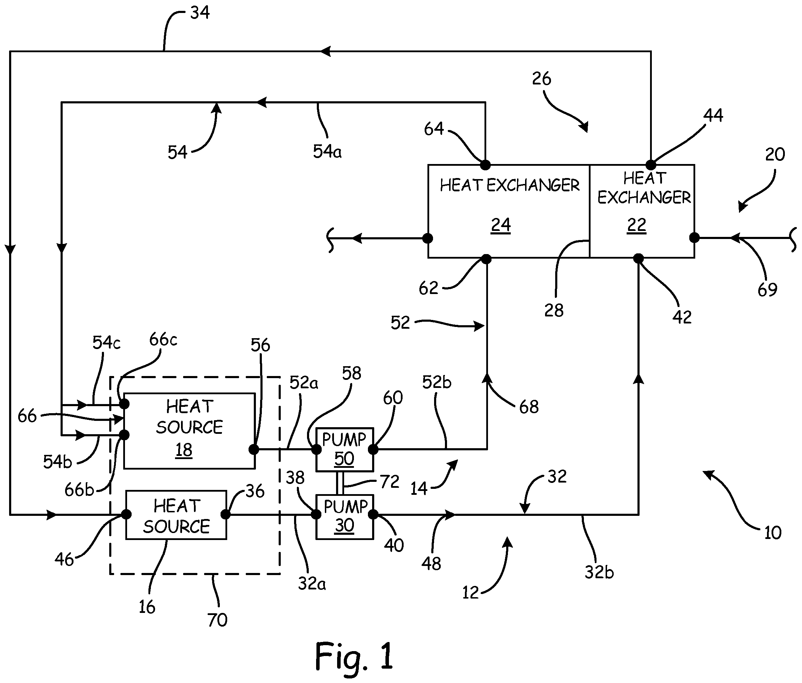

FIG. 1 is a schematic diagram of system 10 that includes cooling circuits 12 and 14, which are arranged in parallel to reject heat produced by sources 16 and 18 to a cooling medium flowing through heat rejection line 20 via heat exchangers 22 and 24, respectively. Heat exchanger 22 is disposed upstream from heat exchanger 24 along line 20, which forms a series flow path through heat exchangers 22 and 24. In some embodiments, heat exchangers 22 and 24 are heat exchanger cores of heat exchanger assembly 26, which are thermally insulated from each other by insulating layer 28 disposed between heat exchangers cores 22 and 24. Thus, system 10 is particularly suited for cooling heat sources 16 and 18 when heat source 18 imposes a heat load on circuit 14 that is greater than a heat load of source 16 imposed on circuit 12.

Cooling circuit 12 includes heat source 16, heat exchanger 22, pump 30, supply line 32, and return line 34. Supply line 32 includes segments 32a and 32b. Supply line segment 32a fluidly connects outlet 36 of heat source 16 to suction side 38 (i.e., inlet side) of pump 30, and supply line segment 32b fluidly connects discharge side 40 (i.e., outlet side) of pump 30 to inlet 42 of heat exchanger 22. Return line 34 fluidly connects outlet 44 of heat exchanger 22 to inlet 46 of heat source 16. Pump 30 is positioned downstream from heat source 16 and upstream from heat exchanger 22 along supply line 32. Pump 30 acts on cooling medium 48 contained within cooling circuit 12 to drive medium 48 through circuit 12 in the direction indicated by the flow arrows in FIG. 1.

Cooling circuit 14 includes heat source 18, heat exchanger 24, pump 50, supply line 52, and return line 54. Supply line 52 includes segments 52a and 52b. Supply line segment 52a fluidly connects outlet 56 of heat source 18 to suction side 58 (i.e., inlet side) of pump 50, and supply line segment 52b fluidly connects discharge side 60 (i.e., outlet side) of pump 50 to inlet 62 of heat exchanger 24. Return line 54 fluidly connects outlet 64 of heat exchanger 24 to at least one inlet 66 of heat source 18. In some embodiments, return line 54 includes main line 54a that forms branch lines 54b and 54c upstream from heat source 18. Branch line 54b fluidly connects supply line 54 to inlet 66b of heat source 18, and branch line 54c fluidly connects supply line 54 to inlet 66c of heat source 18. As will be explained in greater detail below, configuring return line 54 with main line 54a, branch line 54b, and branch line 54c permits return line 54 to provide cooling medium 68 to two zones of heat source 18. Pump 50 acts on cooling medium 68 contained within cooling circuit 14 to drive medium 68 through circuit 14 in the direction indicated by the flow arrows in FIG. 1.

Cooling circuits 12 and 14 circulate cooling mediums 48 and 68, respectively, in order to reject heat produced by heat sources 16 and 18 to a cooling medium in heat rejection line 20 via heat exchangers 22 and 24. Heat exchangers 22 and 24 each communicate with rejection line 20, which has cooling medium 69 flowing in a direction indicated by the flow arrows in FIG. 1. In some embodiments, cooling medium 69 flows through heat exchanger 22 of cooling circuit 12 before flowing through heat exchanger 24 of cooling circuit 14. When heat source 18 produces more heat than heat source 16, locating heat exchanger 22 upstream from heat exchanger 24 along line 20 permits cooling circuit 12 to remain cooler than cooling circuit 14. Thus, because cooling circuit 12 remains cooler than cooling circuit 14, system 10 permits heat source 16 to be located adjacent to heat source 18 within zone 70 (shown schematically in FIG. 1). Moreover, pumps 30 and 50 can be coupled via shaft 72 such that both pumps can be driven by the same source. In some embodiments, pumps are driven by a gearbox attached to the shaft extending from an engine (e.g., a gas turbine engine of an aircraft).

The system 10 is a parallel circuit cooling system when heat source 18 is a generator and heat source 16 is one or more electrical components (i.e., a generator controller) used to operate generator 18 on board an aircraft. Generator 18 is driven by a gas turbine engine located on the aircraft. However, because the gas turbine engine has a variable speed, the rotational speed at which the turbine drives generator 18 changes. Moreover, generator 18 converts mechanical energy from the gas turbine engine into electrical power. The amount of electrical load on generator 18 varies as aircraft systems (i.e., environmental conditioning, radar, and other on-board electrical systems) are engaged and disengaged. Controller 16 monitors the speed of the gas turbine engine and electrical loads imposed on generator 18 and sends control signals to generator 18 such that generator 18 provides a consistent power output. Often the constant speed at the input to the generator is provided in an integrated drive generator unit. The term 'generator' used here includes the integrated drive generator.

Generally, generator 18 contains high temperature rated electromagnetic components that permit generator 18 to operate within higher temperature environments than controller 16, which typically contains printed circuit boards and other less robust components. For example, high temperature rated insulation wires used for generator windings permit generator 18 to operate at or below 200 °C whereas printed circuit boards and like components are typically designed to operate at or below 125 °C. In some embodiments, the temperature of cooling medium 68 at inlets 66b and 66c is equal to or less than 100 °C and the temperature of cooling medium 68 at outlet 56 is equal to or less than 150 °C. Thus, generator 18 is designed to operate such that a temperature margin exists between a temperature of cooling medium 68 at outlet 56 and the maximum temperature allowed by generator 18. This operating margin permits generator 18 to operate at higher temperatures between the maximum normal operating temperature (i.e., 150 °C) and the maximum operating temperature (i.e., 200 °C) for short transient periods. Moreover, generator 18 includes a rotor and a stator as is known in the art. Because the rotor of generator 18 rotates relative to the stator, branch lines 54b and 54c deliver cooling medium 68 to the rotor and stator, respectively.

The less robust components (i.e., printed circuit boards and like components) of controller 16, typically, are not designed to withstand the operational environment enclosing generator 18. Medium 48 flowing within cooling circuit 12 cools controller 16. In some embodiments, the temperature of cooling medium 48 passing through outlet 36 is equal to or less than 100 °C, providing a similar operating margin between the maximum medium temperature at outlet 36 and the maximum allowable temperature of controller 16 (i.e., 125 °C).

Zone 70 is an unpressurized cavity within an aircraft that encloses generator 18 and controller 16. Placing controller 16 in close proximity to generator 18 exposes controller 16 to excess heat produced by generator 18. Additionally, if cooling medium 68 was used to cool controller 16 the temperature of cooling medium 68 passing through controller 16 would exceed the maximum operating temperature of controller 16. As such, the excess heat from generator 18 and the high temperature of cooling medium 68, if used in conjunction with controller 16 would cause controller 16 to exceed its maximum operating temperature. Therefore, system 10 permits generator 18 and controller 16 to be located adjacent to each other and in close proximity within zone 70 because cooling circuit 12 is a parallel to cooling circuit 14. Cooling circuit 12 cools generator 18 separately from controller 16 by using heat exchanger 26. Heat exchanger 26 includes heat exchanger cores 22 and 24 that are thermally-insulated from each other by insulators 28a-c. Additionally, because cooling circuit 12 communicates with heat exchanger 22, which is upstream from heat exchanger 24, the heat load from generator 18 is rejected into cooling medium 69 within line 20 downstream from heat exchanger 22. Thus, cooling medium 48 is maintained at an operating temperature that allows controller 16 to operate at a lower temperature than generator 18 whilst being exposed to the same environmental conditions within zone 70.

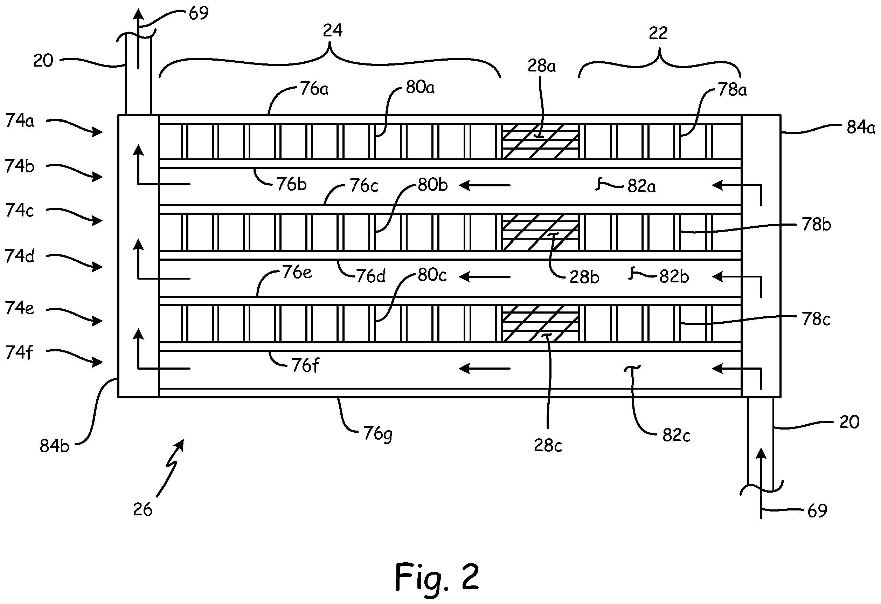

FIG. 2 is a cross-sectional view of heat exchanger 26 taken along a longitudinal axis that is parallel to a flow direction of heat rejection line 20. Heat exchanger 26 is a multi-core heat exchanger having a plate-fin construction in which the first core is heat exchanger 22 and the second core is heat exchanger 24. Heat exchangers 22 and 24 have two or more alternating layers (e.g, six alternating layers 74a-f), that permit medium 48 of cooling circuit 12 and medium 68 of cooling circuit 14 to reject heat to medium 69 of heat rejection line 20.

Layer 74a includes partition plates 76a and 76b, fins 78a and 80a, and insulator 28a. Partition plates 76a and 76b are generally parallel with respect to each other. Fins 78a of heat exchanger 22 are plates extending perpendicular to and between plates 76a and 76b to form a flow path for medium 48 of cooling circuit 12. Likewise, fins 80a of heat exchanger 24 are plates extending perpendicular to and between partition plates 76a and 76b to form a separate flow path for medium 68 of cooling circuit 14. Fins 78a and 80a are generally parallel with respect to each other and with respect to fins 78b, 78c, 80b, and 80c. Insulator 28a is disposed between fins 78a and 80a, thus providing thermal insulation between heat exchanger 22 and heat exchanger 24.

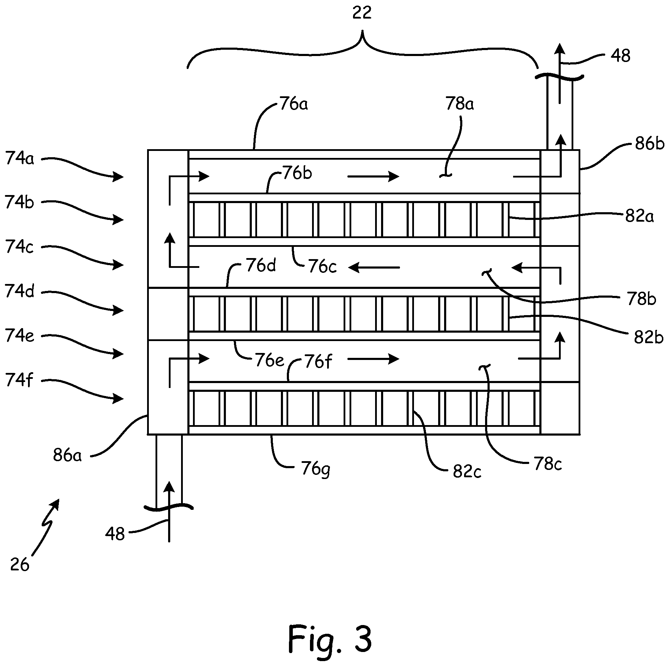

Layer 74b includes partition plates 76b and 76c as well as fins 82a (shown best in FIG. 3). Identically to layer 74a, partition plates 76b and 76c are generally parallel with respect to each other, and fins 82a are generally parallel with respect to each other and extend through layer 74b between partition plates 76b and 76c. However, unlike layer 74a, fins 82 extend in a generally perpendicular direction relative to fins 78a and 80a of layer 74a to form a flow path for medium 69 of heat rejection line 20.

Layer 74c includes partition plates 76c and 76d, fins 78b and 80b, and insulator 28b. Layer 74e includes partition plates 76e and 76f, fins 78c and 80c, and insulator 28c. Layers 74c and 74e are constructed in an identical manner to layer 74a to form flow paths for mediums 48 and 68 of cooling circuits 12 and 14, respectively.

Layer 74d includes partition plates 76d and 76e as well as fins 82b. Layer 74f includes partition plates 76f and 76g as well as fins 82c. Layers 74d and 74f are constructed in an identical manner to layer 74b to form flow paths for medium 69 of heat rejection line 20.

End plates 84a and 84b are disposed along opposing ends of heat exchanger 26 to enclose layers 74a-f. Additionally, end plates 84a and 84b form inlet and outlet manifolds, respectively, for layers 74b, 74d, and 74f,

Layer 74b is arranged between layers 74a and 74c. Likewise, layer 74d is arranged between layers 74c and 74e, and layer 74f is arranged adjacent to layer 74e. Thus, layers 74b, 74d, and 74f, which are configured to permit medium 69 of heat rejection line 20 to flow therein, are arranged such that layers 74a, 74c, and 74e are adjacent to respective layers to place cooling circuits 12 and 14 in a heat exchange relationship with heat rejection line 20.

Insulators 28a, 28b, and 28c are arranged between adjacent fins within a layer to provide thermal insulation between heat exchanger cores 22 and 24. Specifically, positioning insulator 28a between fins 78a and 80a provides thermal insulation between heat exchanger cores 22 and 24 within layer 74a. Similarly, insulator 28b is arranged between fins 78b and 80b, and insulator 28c is arranged between fins 78c and 80c to provide thermal insulation between heat exchanger cores 22 and 24 within layers 74c and 74e, respectively. Together, insulators 28a, 28b, and 28c provide thermal resistance between cooling circuits 12 and 14, permitting cooling circuits 12 and 14 to operate at different temperatures without the hotter circuit unduly heating the cooler circuit. For example, cooling circuit 12 operates at a cooler temperature than cooling circuit 14 when heat source 16 produces less heat than heat source 18.

FIG. 3 is a cross-sectional view of core 22 of heat exchanger 26 taken along a transverse axis that is generally perpendicular to a flow direction of heat rejection line 20. As described above, heat exchanger core 22 includes partition plates 74a and 74b arranged in a parallel relationship to permit fins 78a, extending between plates 74a and 74b to form a flow path for medium 48 of cooling circuit 12 through layer 74a. Layers 74b-74f are constructed as described in reference to FIG. 2 above. Additionally, end plates 86a and 86b extend along opposing sides of heat exchanger 26 to enclose cores 22 and 24 (not shown in FIG. 3). End plates 86a and 86b also form inlet and outlet manifolds for layers 74a, 74c, and 74e, forming a multi-pass flow path through cores 22 and 24 (not shown in FIG. 3). Although, core 24 is not shown in FIG. 3, an identical construction is used. Moreover, end plates 86a and 86b are configured to isolate cooling circuit 12 from cooling circuit 14.

Although heat source 16 and 18 have been described as a controller and generator, heat sources 16 and 18 can also be a motor controller and motor, respectively. Like the controller-generator arrangement described above, a motor generally produces more heat than the controller governing the rotational speed of the motor, and typically, the controller is not designed to withstand the maximum temperature of the motor. Like the controller-generator arrangement, incorporating system 10 into a controller-motor arrangement permits the controller (i.e., heat source 16) to be located within the same higher temperature environment (i.e., zone 70) as the motor (i.e., heat source 18). In a controller-motor arrangement, system 10 is configured and operates as described with respect to the controller-generator arrangement.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A system (10) comprising:
a heat exchanger (26) comprising:
a first core (22) defining a first flow path through the heat exchanger (26);
a second core (24) defining a second flow path through the heat exchanger (26) that is parallel to the first flow path, wherein the first and second cores (22, 24) define a third flow path extending through the heat exchanger (26) that is configured to be in a heat exchange relationship with the first and second flow paths; and
a thermal barrier (28) disposed between the first and second cores (22, 24) such that the first and second flow paths are thermally insulated from each other;
a first heat source (16) disposed along a first circuit (12) that includes the first flow path of the heat exchanger (26); and
a second heat source (18) disposed along a second circuit (14) that includes the second flow path of the heat exchanger (26), wherein a heat load generated by the second heat source (18) is greater than a heat load generated by the first heat source (16);
**characterised in that**:
the second heat source (18) is a generator for an aircraft and the first heat source (16)
includes electronic components disposed adjacent to the generator (18) and configured to control an electrical output of the generator (18); and
an unpressurized cavity (70) of an aircraft encloses the generator (18) and the controller (16).

2. The system (10) of claim 1, further comprising:
a first pump (30) disposed between the electronic components and the heat exchanger (22) along the first circuit (12); and
a second pump (50) disposed between the generator and the heat exchanger (24) along the second circuit (14), wherein the first and second pumps (30, 50) are driven by a gas turbine engine.

3. The system (10) of claim 1 or 2, wherein the third flow path defines a portion of a fuel system.

4. The system (10) of claim 1, 2 or 3, wherein:
the first and second cores (22, 24) include multiple alternating layers (74a-f) of fins (78a-c, 80a-c) and plates (76a-f), and
the thermal barrier (28) includes multiple thermal insulators (28a-c) in which each insulator (28a-c) is disposed between fins (78a-c) of the first core (22) and fins (80a-c) of the second core (24) that are adjacent to the fins (78a-c) of the first core (22).

5. The system (10) of claim 4, wherein the first and second cores (22, 24) are integrated into a single heat exchanger body (26).

6. A method of using the system (10) of claim 1, comprising:
passing a first medium (48) through the first circuit (12), wherein the first medium (48) is in a heat exchange relationship with the first heat source (16) and the first core (22);
passing a second medium (68) through the second circuit (14), wherein the second medium (68) is in a heat exchange relationship with the second heat source (18) and the second core (24);
passing a third medium (69) through the first and second cores (22, 24), in series, to reject heat from the first and second heat sources (16, 18).

7. The method of claim 6, wherein:
passing the first medium (48) through the first circuit (12) includes using a first pump (30) disposed between the first heat source (16) and the first core (22) along a first supply line (32) to circulate the first medium (48) through the first circuit (12); and
passing the second medium (68) through the second circuit (14) includes using a second pump (50) disposed between the second heat source (18) and the second core (24) along a second supply line (52) to circulate the second medium (68) through the second circuit (14).

8. The method of claim 6 or 7 and further comprising:
passing the second medium (68) through a first branch (54c) of a second return line (54) to place the second medium (68) in a heat exchange relationship with a stator of the generator, wherein the second return line (54) extends from the second heat exchanger (24) to the generator; and
passing the second medium (68) through a second branch (54b) of the second return line (54) to place the second medium (68) in a heat exchange relationship with a rotor of the generator.

9. The method of claim 7 or 8 and further comprising:
driving the first and second pumps (30, 50) with the generator (18).

10. The method of any of claims 6 to 9, wherein:
the first and second mediums (48, 68) are liquid heat exchange fluids; and
the third medium is fuel (69).

## Patentansprüche

1. System (10), umfassend:
einen Wärmetauscher (26), umfassend:
einen ersten Kern (22), der einen ersten Strömungspfad durch den Wärmetauscher (26) definiert;
einen zweiten Kern (24), der einen zweiten Strömungspfad durch den Wärmetauscher (26) definiert, welcher parallel zum ersten Strömungspfad verläuft, wobei der erste und zweite Kern (22, 24) einen dritten Strömungspfad definieren, der sich durch den Wärmetauscher (26) erstreckt, welcher so konfiguriert ist, dass er sich in einem Wärmetauschverhältnis mit dem ersten und zweiten Strömungspfad befindet; und
eine Wärmesperre (28), die zwischen dem ersten und zweiten Kern (22, 24) angeordnet ist, sodass der erste und zweite Strömungspfad voneinander wärmeisoliert sind;
eine erste Wärmequelle (16), die entlang eines ersten Kreislaufes (12) angeordnet ist, der den ersten Strömungspfad des Wärmetauschers (26) umfasst; und
eine zweite Wärmequelle (18), die entlang eines zweiten Kreislaufes (14) angeordnet ist, der den zweiten Strömungspfad des Wärmetauschers (26) umfasst, wobei eine durch die zweite Wärmequelle (18) erzeugte Wärmelast größer als eine durch die erste Wärmequelle (16) erzeugte Wärmelast ist;
**dadurch gekennzeichnet, dass**:
die zweite Wärmequelle (18) ein Generator für ein Luftfahrzeug und die erste Wärmequelle (16) ist;
es elektronische Komponenten umfasst, die angrenzend an den Generator (18) angeordnet sind und so konfiguriert sind, dass sie einen elektrischen Ausgang des Generators (18) regeln; und
ein druckloser Hohlraum (70) eines Luftfahrzeugs den Generator (18) und die Steuerung (16) umschließt.

2. System (10) nach Anspruch 1, ferner umfassend:
eine erste Pumpe (30), die zwischen den elektronischen Komponenten und dem Wärmetauscher (22) entlang des ersten Kreislaufes (12) angeordnet ist; und
eine zweite Pumpe (50), die zwischen dem Generator und dem Wärmetauscher (24) entlang des zweiten Kreislaufes (14) angeordnet ist, wobei die erste Pumpe und die zweite Pumpe (30, 50) durch ein Gasturbinentriebwerk angetrieben werden.

3. System (10) nach Anspruch 1 oder 2, wobei der dritte Strömungspfad einen Abschnitt eines Brennstoffsystems definiert.

4. System (10) nach Anspruch 1, 2 oder 3, wobei:
der erste Kern und der zweite Kern (22, 24) mehrere wechselnde Schichten (74a-f) der Flügel (78a-c, 80a-c) und Platten (76a-f) umfassen, und
die Wärmesperre (28) mehrere thermische Isolierkörper (28a-c) umfasst, in der jeder Isolator (28a-c) zwischen den Flügeln (78a-c) des ersten Kerns (22) und den Flügeln (80a-c) des zweiten Kerns (24) angeordnet ist, die an die Flügel (78a-c) des ersten Kerns (22) angrenzen.

5. System (10) nach Anspruch 4, wobei der erste und zweite Kern (22, 24) in einen einzigen Wärmetauscherkörper (26) integriert sind.

6. Verfahren zur Verwendung des Systems (10) nach Anspruch 1, umfassend:
Leiten eines ersten Mediums (48) durch den ersten Kreislauf (12), wobei das erste Medium (48) in einem Wärmetauschverhältnis mit der ersten Wärmequelle (16) und dem ersten Kern (22) steht;
Leiten eines zweiten Mediums (68) durch den zweiten Kreislauf (14), wobei das zweite Medium (68) in einem Wärmetauschverhältnis mit der zweiten Wärmequelle (18) und dem zweiten Kern (24) steht;
Serielles Leiten eines dritten Mediums (69) durch den ersten und zweiten Kern (22, 24), um Wärme aus der ersten und zweiten Wärmequelle (16, 18) abzuführen.

7. Verfahren nach Anspruch 6, wobei:
das Leiten des ersten Mediums (48) durch den ersten Kreislauf (12) die Verwendung einer ersten Pumpe (30) umfasst, die zwischen der ersten Wärmequelle (16) und dem ersten Kern (22) entlang einer ersten Zufuhrleitung (32) angeordnet ist, um das erste Medium (48) durch den ersten Kreislauf (12) zu leiten; und
das Leiten des zweiten Mediums (68) durch den zweiten Kreislauf (14) die Verwendung einer zweiten Pumpe (50) umfasst, die zwischen der zweiten Wärmequelle (18) und dem zweiten Kern (24) entlang einer zweiten Zufuhrleitung (52) angeordnet ist, um das zweite Medium (68) durch den zweiten Kreislauf (14) zu leiten.

8. Verfahren nach Anspruch 6 oder 7 und ferner umfassend:
Leiten des zweiten Mediums (68) durch einen ersten Zweig (54c) einer zweiten Rückführleitung (54), um das zweite Medium (68) in ein Wärmetauschverhältnis mit einem Stator des Generators zu bringen, wobei sich die zweite Rückführleitung (54) vom zweiten Wärmetauscher (24) zum Generator erstreckt; und
Leiten des zweiten Mediums (68) durch einen zweiten Zweig (54b) der zweiten Rückführleitung (54), um das zweite Medium (68) in ein Wärmetauschverhältnis mit einem Rotor des Generators zu bringen.

9. Verfahren nach Anspruch 7 oder 8 und ferner umfassend:
Antreiben der ersten und zweiten Pumpe (30, 50) mit dem Generator (18).

10. Verfahren nach einem der Ansprüche 6 bis 9, wobei:
das erste und zweite Medium (48, 68) flüssige Wärmetauschfluids sind; und
das dritte Medium ein Brennstoff (69) ist.

## Revendications

1. Système (10) comprenant :
un échangeur de chaleur (26) comprenant :
un premier faisceau (22) définissant un premier chemin d'écoulement à travers l'échangeur de chaleur (26) ;
un second faisceau (24) définissant un deuxième chemin d'écoulement à travers l'échangeur de chaleur (26) qui est parallèle au premier chemin d'écoulement, dans lequel les premier et second faisceaux (22, 24) définissent un troisième chemin d'écoulement s'étendant à travers l'échangeur de chaleur (26) qui est configuré pour être dans une relation d'échange de chaleur avec les premier et deuxième chemins d'écoulement ; et
une barrière thermique (28) disposée entre les premier et second faisceaux (22, 24) pour que les premier et deuxième chemins d'écoulement soient isolés thermiquement l'un de l'autre ;
une première source de chaleur (16) disposée le long d'un premier circuit (12) qui inclut le premier chemin d'écoulement de l'échangeur de chaleur (26) ; et
une seconde source de chaleur (18) disposée le long d'un second circuit (14) qui inclut le deuxième chemin d'écoulement de l'échangeur de chaleur (26), dans lequel une charge calorifique générée par la seconde source de chaleur (18) est plus grande qu'une charge calorifique générée par la première source de chaleur (16) ;
**caractérisé en ce que** :
la seconde source de chaleur (18) est un générateur pour un aéronef et la première source de chaleur (16) inclut des composants électroniques disposés adjacents au générateur (18) et configurés pour commander une sortie électrique du générateur (18) ; et
une cavité non pressurisée (70) d'un aéronef renferme le générateur (18) et l'unité de commande (16).

2. Système (10) selon la revendication 1, comprenant en outre : une première pompe (30) disposée entre les composants électroniques et l'échangeur de chaleur (22) le long du premier circuit (12) ; et
une seconde pompe (50) disposée entre le générateur et l'échangeur de chaleur (24) le long du second circuit (14), dans lequel les première et seconde pompes (30, 50) sont entraînées par un moteur à turbine à gaz.

3. Système (10) selon la revendication 1 ou 2, dans lequel le troisième chemin d'écoulement définit une portion d'un système de carburant.

4. Système (10) selon la revendication 1, 2 ou 3, dans lequel : les premier et second faisceaux (22, 24) incluent de multiples couches alternées (74a à f) d'ailettes (78a à c, 80a à c) et des plaques (76a à f), et
la barrière thermique (28) inclut de multiples isolants thermiques (28a à c) dans lesquels chaque isolant (28a à c) est disposé entre des ailettes (78a à c) du premier faisceau (22) et des ailettes (80a à c) du second faisceau (24) qui sont adjacents aux ailettes (78a à c) du premier faisceau (22).

5. Système (10) selon la revendication 4, dans lequel les premier et second faisceaux (22, 24) sont intégrés en un seul corps d'échangeur de chaleur (26).

6. Procédé d'utilisation du système (10) de la revendication 1, comprenant :
le fait de passer un premier milieu (48) à travers le premier circuit (12), dans lequel le premier milieu (48) est dans une relation d'échange de chaleur avec la première source de chaleur (16) et le premier faisceau (22) ;
le fait de faire passer un second milieu (68) à travers le second circuit (14), dans lequel le second milieu (68) est dans une relation d'échange de chaleur avec la seconde source de chaleur (18) et le second faisceau (24) ;
le fait de faire passer un troisième milieu (69) à travers les premier et second faisceaux (22, 24), en série, pour rejeter la chaleur issue des première et seconde sources de chaleur (16, 18).

7. Procédé selon la revendication 6, dans lequel :
le fait de faire passer le premier milieu (48) à travers le premier circuit (12) inclut l'utilisation d'une première pompe (30) disposée entre la première source de chaleur (16) et le premier faisceau (22) le long d'une première ligne d'alimentation (32) pour faire circuler le premier milieu (48) à travers le premier circuit (12) ; et
le fait de faire passer le second milieu (68) à travers le second circuit (14) inclut l'utilisation d'une seconde pompe (50) disposée entre la seconde source de chaleur (18) et le second faisceau (24) le long d'une seconde ligne d'alimentation (52) pour faire circuler le second milieu (68) à travers le second circuit (14).

8. Procédé selon la revendication 6 ou 7 et comprenant en outre :
le fait de faire passer le second milieu (68) à travers une première branche (54c) d'une seconde ligne de retour (54) pour placer le second milieu (68) dans une relation d'échange de chaleur avec un stator du générateur, dans lequel la seconde ligne de retour (54) part du second échangeur de chaleur (24) vers le générateur ; et
le fait de faire passer le second milieu (68) à travers une seconde branche (54b) de la seconde ligne de retour (54) pour placer le second milieu (68) dans une relation d'échange de chaleur avec un rotor du générateur.

9. Procédé selon la revendication 7 ou 8 et comprenant en outre :
l'entraînement des première et seconde pompes (30, 50) avec le générateur (18).

10. Procédé selon l'une quelconque des revendications 6 à 9, dans lequel :
les premier et second milieux (48, 68) sont des fluides d'échange de chaleur de liquide ; et
le troisième milieu est du carburant (69).
